# EUROPEAN PATENT SPECIFICATION

(11) **EP 1 892 314 B1**
(45) Date of publication and mention of the grant of the patent: **11.04.2012**
(21) Application number: 06119488.2
(22) Date of filing: 24.08.2006
(51) Int. Cl.: C23C 14/34, H01J 37/34

(54) **Circulated cooled target**
Targethalterung mit einer Kühleinrichtung
cible de pulvérisation refroidie par circulation

(43) Date of publication of application: 27.02.2008
(73) Proprietor: Atomic Energy Council - Institute of Nuclear Energy Research, Lungtan, Taoyuan, Taiwan (TW)
(72) Inventor: Lin, Wuu-Jyh, 325 Longtan Township, Taoyuan County (TW); Chang, Mao-Hsung, 303, Hukou Township, Hsinchu County (TW); Huang, Ping-Yen, 357, Tongsiao Township, Miaoli County (TW); Chen, Jenn-Tzong, 115, Taipei City (TW); Duh, Ting-Shien, 325, Longtan Township, Taoyuan County (TW); Chen, Dow-Che, 335, Dasi Township, Taoyuan County (TW); Chu, Kuo-Yuan, 335, Dasi Township, Taoyuan County (TW)
(74) Representative: Beck, Michael Rudolf

(56) References cited:
- EP-A1- 0 045 822
- WO-A-98/37568
- US-A- 4 434 042

## Description

### Field of the invention

The present invention relates to cooling a target; more particularly, relates to cooling down a target chamber effectively.

### Description of the Related Art

The applicant is aware of prior art sputtering equipment comprising a machine room for sputtering a wafer; a target pole departed from the wafer above the machine room; a backplate having the target pole below and having a cooling gas tubing within, the cooling gas tubing having a cooling gas for cooling the target pole by recycling; and a cooling gas supplier providing and recycling the cooling gas to and in the cooling gas tubing.

The sputtering equipment has a sputtering method comprising the following steps:
a) Water is loaded on a crystal housing in the machine room.
b) By applying 15kW (kilo watt) to 45kW of a high frequency power to the target pole, a reaction gas is supplied to the sputtering equipment at a rate of 3 standard cubic centimeters per minute (SCCM) to 10SCCM to maintain an inner pressure of the sputtering equipment at 0.1 milliTorr (mTorr) to 1mTorr to sputter and deposit a target material on the wafer.

Thus, a sputtering method for ladder coating under a certain speed is obtained.

Although the above prior art obtains a sputtering method for ladder coating under a certain speed, the cooling gas tubing does not have a cooling effect good enough to sustain a high temperature produced on irradiating a proton beam on the target material. Hence, the prior art does not fulfill users' requests on actual use.

An internally cooled target assembly for magnetron sputtering including coolant channels is known from WO 98/37568.

### Summary of the invention

The present application aims at improving cooling.

This technical problem is solved by a circulated cooled target as defined in claim 1. Advantageous embodiments are indicated in further claims.

The main purpose of the present invention is to fill in a required liquid and a required gas from a liquid inlet and a gas inlet of a first target chamber for circulating a concave part of a carrier element and outputting from an outlet of a second target chamber to cool down a cooling target effectively.

### Brief descriptions of the drawings

The present invention will be better understood from the following detailed description of the preferred embodiment according to the present invention, taken in conjunction with the accompanying drawings, in which
FIG.1 is a perspective view showing the preferred embodiment of the present invention;
FIG.2 is a first explosive view of the preferred embodiment;
FIG.3 is a second explosive view;
FIG.4 is a side view showing the state of use; and
FIG.5 is a sectional view showing the state of use.

### Description of a preferred embodiment

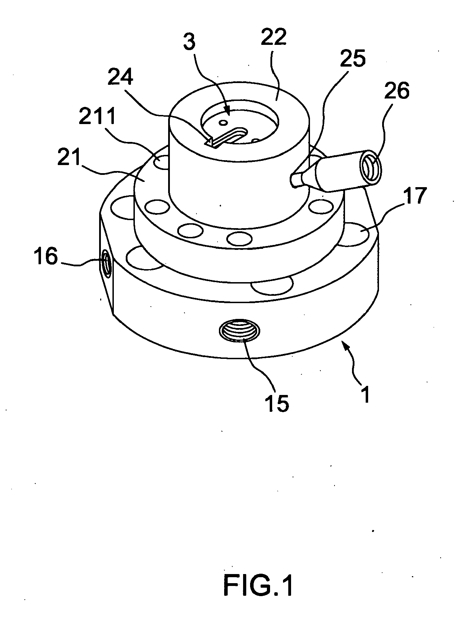

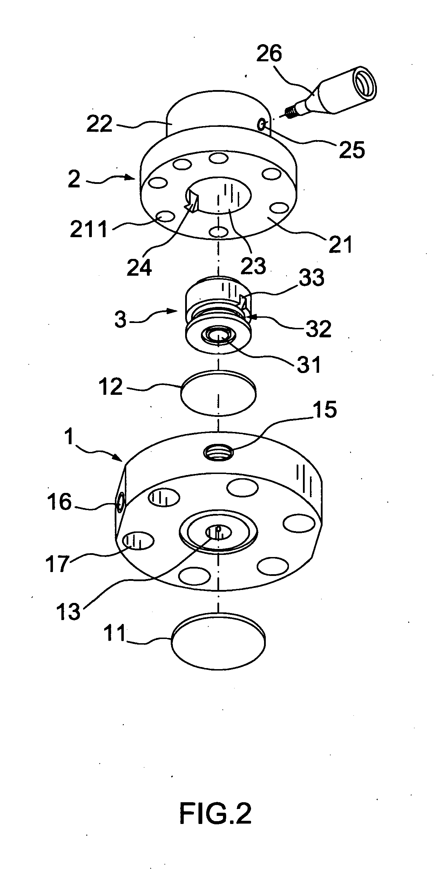

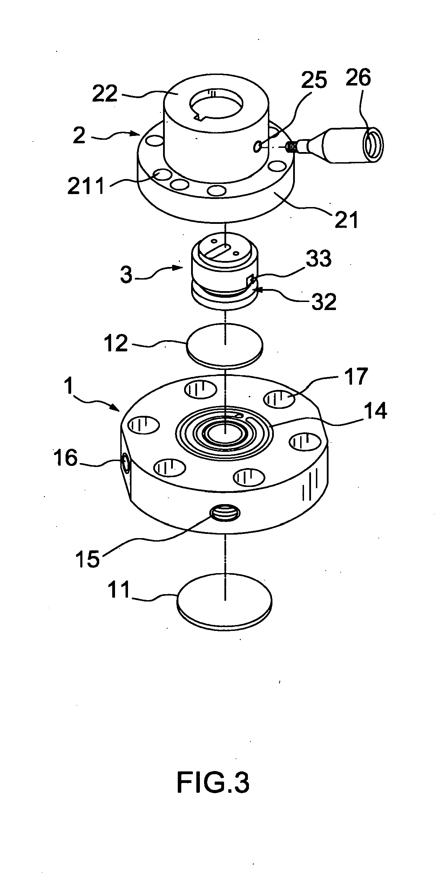

FIG.1, FIG.2 and FIG.3 show a preferred embodiment of a circulated cooled target, comprising a first target chamber 1, a second target chamber 2 and a carrier element 3, where a required cooling gas and a required cooling liquid are filled into the first target chamber 1 and is flown out from the second target chamber 2 after circulating the carrier element 3 to cool down the target.

The first target chamber 1 has a hole part 13 at center and the hole part 13 has a first foil layer 11 and a second foil layer 12 at two opposite ends; has a flow channel 14 on a surface of the first target chamber 1 encircling the hole part 13; has a liquid inlet 15 and a gas inlet 16 on outside surface of the first target chamber 1 to connect to the flow channel 14; and has a plurality of first fixing holes 17.

The second target chamber 2 comprises a disc lump 21; and an extension part 22 on a side surface of the disc lump 21. The disc lump 21 is deposed on a surface of the first target chamber 1 which surface has the flow channel 14. The disc lump 21 has a plurality of second fixing holes 211 corresponding to the first fixing holes 17 of the first target chamber 1 to be locked by a plurality of fixing members (not shown in the figures) through the first and the second fixing holes 17,211. The second target chamber 2 has a communicating chamber 23 at center penetrating through the disc lump 21 and the extension part 22. The communicating chamber 23 has a concave 24 deposed on the disc lump 21 at a proper position of a rim of the communicating chamber 23. The second target chamber 2 has an outlet 25 on an outside surface of the extension part 22 and the outlet 25 connects to the communicating chamber 23. And the outlet 25 is connected with a tubing 26.

The carrier element 3 is located in the communicating chamber 23; and has a store part 31 on an end surface and a concave part 32 which encircles the carrier element 3. And the concave part 32 has a gap 33 at a proper position of a side of the concave part 32. Thus, a novel circulated cooled target is obtained.

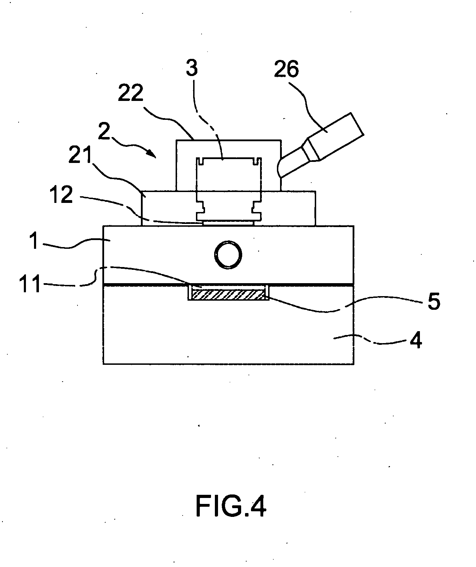

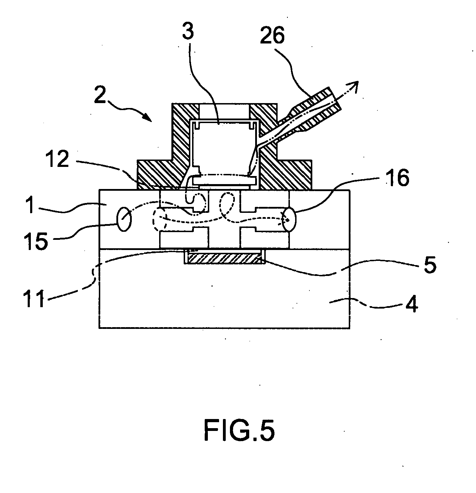

FIG.4 and FIG.5 are a side view and a sectional view showing a state of use. As shown in the figures, when using the present invention, a vacuum chamber 4 is connected to a first target chamber 1; a target material 5 is then put on a store part 31 of a carrier element 3 to be irradiated with a proton beam from a side of the first target chamber 1; and water and helium gas is filled in from a liquid inlet 15 and a gas inlet of the first target chamber 1 respectively. A first foil layer 11 is used to make the first target chamber 1 airtight, and a second foil layer is used to prevent liquid isotope from leaking when processing a reaction of the target material 5. As the water and the helium gas are filled in from the liquid inlet 15 and the gas inlet 16, the water and the helium gas are flown to a concave part 32 of the carrier element 3; then the water and the helium gas circulate the concave part 32 and is flown out from an outlet 25 of a second target chamber 2 to be guided to a required place by a tubing 26. By doing so, the carrier element 3 is effectively cooled down by the circulating of the water and the helium gas.

To sum up, the present invention is a circulated cooled target, where a required cooling water and a required cooling gas is filled into a first target chamber from a liquid inlet and a gas inlet to cool down the target by circulating a carrier element coordinated with a concave part and then being flown out from an outlet of a second target chamber.

## Claims

1. A circulated cooled target, comprising:
a first target chamber (1) having at its center a hole part (13), said hole part having a first foil layer (11) at an end of said hole part (13) and a second foil layer (12) at the opposite end of said hole part (13), said first target chamber (1) having a flow channel (14) encircling said hole part (13) at a rim of said hole part (13) on a surface of said first target chamber (1), said first target chamber (1) having a liquid inlet (15) and a gas inlet (16) on an outside surface of said first target chamber, said liquid inlet (15) and said gas inlet (16) both connecting to said flow channel (14);
a second target chamber (2)arranged on the surface of said first target chamber (1) which surface has said flow channel (14), said second target chamber (2) having at its center a communicating chamber (23), said communicating chamber (23) having a concave (24) at a rim of said communicating chamber (23), said second target chamber (2) having an outlet (25) on an outside surface of said second target chamber (2), said outlet (25) connecting to said communicating chamber (23); and
a carrier element (3) located in said communicating chamber (23), said carrier element (3) having a store part (31) at an end surface of said carrier element (3), said carrier element (3) having a concave part (32) encircling said carrier element, said concave part having a gap (33) at a position at a side of said concave part (32).

2. The target according to claim 1,
wherein said first target chamber (1) and said second target chamber (2) have a plurality of first fixing holes (17) and a plurality of second fixing holes (211), respectively, to be locked by a plurality of fixing members; and
wherein said first fixing holes (17) of said first target chamber (1) and said second fixing holes (211) of said second target chamber (2) are corresponding to each other separately.

3. The target according to claim 1,
wherein said second target chamber (2) comprises a disc lump (21) and an extension part (22) and said extension part (22) is arranged on a side surface of said disc lump (21);
wherein said communicating chamber (23) is penetrated through said disc lump (21) and said extension part (23);
wherein said concave (24) is arranged on said disc lump (21); and
wherein said outlet (25) is arranged on an outside surface of said extension part (22).

4. The target according to claim 1, wherein said outlet (25) of said second target chamber (2) is connected with a tubing (26).

## Patentansprüche

1. Umlaufgekühltes Target, umfassend:
eine erste Targetkammer (1) mit einem Lochabschnitt (13) in der Mitte, wobei der Lochabschnitt eine erste Folienschicht (11) an einem Ende des Lochabschnitts (13) und eine zweite Folienschlicht (12) am gegenüber liegenden Ende des Lochabschnitts (13) aufweist, die erste Targetkammer (1) einen Fließkanal (14) aufweist, der den Lochabschnitt (13) an einem Rand des Lochabschnitts (13) an einer Oberfläche der ersten Targetkammer (1) umschließt, die erste Targetkammer (1) einen Flüssigkeitseinlass (15) und einen Gaseinlass (16) an einer Außenfläche der ersten Targetkammer aufweist, wobei der Flüssigkeitseinlass (15) und der Gaseinlass (16) beide mit dem Fließkanal (14) verbunden sind;
eine zweite Targetkammer (2), die an der Oberfläche der ersten Targetkammer (1) angeordnet ist, wobei diese Oberfläche den Fließkanal (14) aufweist, die zweite Targetkammer (2) eine Verbindungskammer (23) in der Mitte hat und die Verbindungskammer (23) eine Hohlrundung (24) an einem Rand der Verbindungskammer (23) aufweist, die zweite Targetkammer (2) einen Auslass (25) an einer Außenfläche der zweiten Targetkammer (2) aufweist, wobei der Auslass (25) mit der Verbindungskammer (23) verbunden ist; und
ein Trägerelement (3), das in der Verbindungskammer (23) angeordnet ist, wobei das Trägerelement (3) einen Speicherabschnitt (31) an einer Endfläche des Trägerelements (3) aufweist, das Trägerelement (3) einen konkaven Abschnitt (32) aufweist, der das Trägerelement umschließt und der konkave Abschnitt an einer Stelle an einer Seite des konkaven Abschnitts (32) über eine Spaltöffnung (33) verfügt.

2. Target nach Anspruch 1,
wobei die erste Targetkammer (1) und die zweite Targetkammer (2) eine Vielzahl von ersten Fixieröffnungen (17) bzw. eine Vielzahl von zweiten Fixieröffnungen (211) aufweisen, die mit einer Vielzahl von Fixierelementen fixierbar sind; und
wobei die ersten Fixieröffnungen (17) der ersten Targetkammer (1) und die zweiten Fixieröffnungen (211) der zweiten Targetkammer (2) für sich miteinander korrespondieren.

3. Target nach Anspruch 1,
wobei die zweite Targetkammer (2) ein Scheibenstück (21) und einen verlängerten Abschnitt (22) umfasst, und der verlängerte Abschnitt (22) an einer Seitenfläche des Scheibenstücks (21) angeordnet ist;
wobei die Verbindungskammer (23) durch das Scheibenstück (21) und den verlängerten Abschnitt (23) hindurchführt;
wobei die Hohlrundung (24) an dem Scheibenstück (21) angeordnet ist; und
wobei der Auslass (25) an einer Außenfläche des verlängerten Abschnitts (22) angeordnet ist.

4. Target nach Anspruch 1, wobei der Auslass (25) der zweiten Targetkammer (2) mit einer Rohrleitung (26) verbunden ist.

## Revendications

1. Cible refroidie par circulation comprenant :
un première chambre cible (1) ayant en son centre une partie trou (13), ladite partie trou ayant une première couche de feuille (11) à une extrémité de ladite partie trou (13) et une seconde couche de feuille (12) à l'extrémité opposée de ladite partie trou (13), ladite première chambre cible (1) ayant un canal d'écoulement (14) qui encercle ladite partie trou (13) sur un bord de ladite partie trou (13) sur une surface de ladite première chambre cible (1), ladite première chambre cible (1) ayant une entrée de liquide (15) et une entrée de gaz (16) sur une surface extérieure de ladite première chambre cible, ladite entrée de liquide (15) et ladite entrée de gaz (16) étant toutes deux reliées audit canal d'écoulement (14),
une seconde chambre cible (2) arrangée sur la surface de la première chambre cible (1), laquelle surface a ledit canal d'écoulement (14), ladite seconde chambre cible (2) ayant en son centre une chambre communicante (23), ladite chambre communicante (23) ayant une partie concave (24) sur un bord de ladite chambre communicante (23), ladite seconde chambre cible (2) ayant une sortie (25) sur une surface extérieure de la dite seconde chambre cible (2), ladite sortie (25) étant reliée à ladite chambre communicante (23) et
un élément porteur (3) situé dans ladite chambre communicante (23), ledit élément porteur (3) ayant une partie stock (31) sur une surface d'extrémité dudit élément porteur (3), ledit élément porteur (3) ayant une partie concave (32) qui encercle ledit élément porteur, ladite partie concave ayant une fente (33) à une position sur un côté de ladite partie concave (32).

2. Cible selon la revendication 1,
dans laquelle ladite première chambre cible (1) et ladite seconde chambre cible (2) ont chacune une pluralité de premiers trous de fixation (17) et une pluralité de seconds trous de fixation (211) pour être verrouillés par une pluralité d'éléments de fixation et dans laquelle lesdits premiers trous de fixation (17) de ladite première chambre cible (1) et lesdits seconds trous de fixation (211) de ladite seconde chambre cible (2) sont correspondants l'un à l'autre séparément.

3. Cible selon la revendication 1,
dans laquelle ladite seconde chambre cible (2) comprend un morceau de disque (21) et une partie d'extension (22) et ladite partie d'extension (22) est arrangée sur une surface de côté dudit morceau de disque (21),
dans laquelle ladite chambre communicante (23) est pénétrée par ledit morceau de disque (21) et ladite partie d'extension (23),
dans laquelle ladite partie concave (24) est arrangée sur ledit morceau de disque (21) et
dans laquelle ladite sortie (25) est arrangée sur une surface extérieure de ladite partie d'extension (22).

4. Cible selon la revendication 1 dans laquelle ladite sortie (25) de ladite seconde chambre cible (2) est reliée à un tuyau (26).
